# FASCICULE DE BREVET EUROPEEN

(11) **EP 3 509 219 B1**
(45) Date de publication et mention de la délivrance du brevet: **22.07.2020**
(21) Numéro de dépôt: 19150013.1
(22) Date de dépôt: 02.01.2019
(51) Int. Cl.: H03K 19/017, H03K 19/096

(54) **COMPARATEUR COMPENSE**
KOMPENSIERTER KOMPARATOR
COMPENSATED COMPARATOR

(30) Priorité: 04.01.2018 FR 1850031
(43) Date de publication de la demande: 10.07.2019
(73) Titulaire: COMMISSARIAT À L'ÉNERGIE ATOMIQUE ET AUX ÉNERGIES ALTERNATIVES, 75015 Paris (FR)
(72) Inventeur: VERDANT, Arnaud, 38330 Saint Nazaire Les Eymes (FR)
(74) Mandataire: Brevalex

(56) Documents cités:
- EP-A1- 0 695 035
- WO-A1-2017/089596
- WO-A2-03/014913

## Description

### DOMAINE TECHNIQUE

La présente invention concerne un comparateur. En particulier, la présente invention concerne un comparateur compensé qui comprend un étage différentiel pourvu de deux transistors.

### ART ANTÉRIEUR

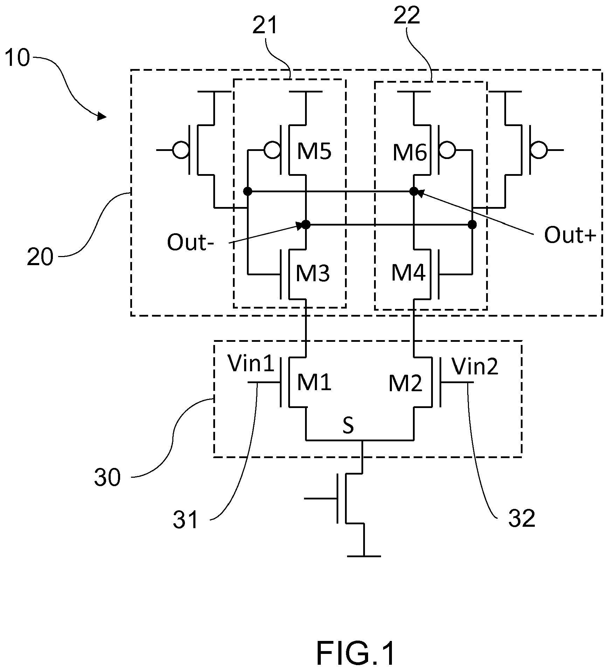

Le document WO 03/014913 A2 décrit un comparateur avec un étage différentiel. En outre un comparateur 10 connu de l'état de la technique et illustré à la figure 1 comprend :
- un étage de décision 20 destiné à délivrer un signal de sortie représentatif de la comparaison d'un premier Vᵢₙ₁ et d'un second Vᵢₙ₂ potentiels d'entrée imposés, respectivement, à une première 31 et à une seconde 32 bornes d'entrée du comparateur ;
- un étage différentiel 30 comprenant des premier M1 et second M2 transistors identiques, reliés par leurs sources en un nœud S, et connectés par leurs drains respectifs à l'étage de décision, et dont les grilles forment respectivement, la première 31 et la seconde 32 bornes d'entrée du comparateur.

L'étage de décision 20 peut, par exemple, comprendre deux inverseurs CMOS 21, 22 (ci-après « inverseur ») montés en contre-réaction. En particulier, chaque inverseur 21, 22 comprend un transistor NMOS M3, M4 et un transistor PMOS M5, M6 reliés par leurs drains en des points Out-, Out+ formant les sorties du comparateur 10.

En fonctionnement, un signal de sortie peut basculer soit dans un premier état soit dans un second état en fonction du signe de la différence de potentiel Vᵢₙ₁ - Vᵢₙ₂.

Cependant, un tel comparateur connu de l'état de la technique n'est pas satisfaisant.

En effet, les caractéristiques du comparateur 10, et en particulier les tensions de seuil des transistors M1 et M2, qui sont sensibles aux dispersions technologiques et notamment à l'erreur de gravure des canaux desdits transistors, peuvent varier d'un comparateur à l'autre.

Ainsi, une dispersion importante, de l'ordre de 50 mV (± 3σ) du point de basculement du signal de sortie est observée d'un comparateur à l'autre.

Afin de pallier ce problème, les documents [1] et [2] cités à la fin de la description proposent d'effectuer une calibration du comparateur. Cependant les méthodes et agencements proposés dans ces documents génèrent une consommation de puissance supplémentaire qui n'est pas souhaitable, notamment lorsque le comparateur est intégré à un capteur d'images.

Ainsi, un but de la présente invention est de proposer un agencement permettant de réduire la dispersion du point de basculement d'un comparateur à l'autre et pour lequel la consommation de puissance est faible.

### EXPOSÉ DE L'INVENTION

Le but de la présente invention est, au moins en partie, atteint par un comparateur compensé comprenant :
- des première et seconde entrées destinées à recevoir respectivement des premier Vin1 et second Vin2 potentiels à comparer ;
- un étage différentiel doté de premier et second transistors de même type, reliés par leurs sources en un nœud S et comprenant chacun une grille dite, respectivement, première et seconde grille,
- un étage de décision relié aux drains des premier et second transistors et délivrant un signal de comparaison sur une sortie du comparateur ;
caractérisé en ce qu'il comprend
- des premier et second condensateurs intercalés, respectivement, entre la première grille et la première entrée et entre la seconde grille et la seconde entrée,
- des premier et second commutateurs de décision placés entre l'étage de décision et les drains des premier et second transistors de l'étage différentiel ;
- des dispositifs de précharge, de partage, et de décision commandés par un circuit de contrôle, pour mettre en œuvre des phases successives de précharge, de partage et de décision,
le dispositif de précharge permettant d'imposer une charge aux premier et second condensateurs de sorte qu'une tension de précharge soit présente aux bornes des condensateurs en fin de phase de précharge,
le dispositif de partage permettant de court-circuiter la grille et le drain de chacun des premier et second transistors, les courts-circuits provoquant un transfert de charge des premier et second condensateurs vers le nœud S, le transfert s'interrompant dès lors que les tensions grille-source des premier et second transistors deviennent inférieures aux tensions de seuil respectives des premier et second transistors, et
le dispositif de décision permettant de rendre passants lesdits commutateurs de décision pour réaliser la comparaison entre les premier et second potentiels d'entrée appliqués sur les première et seconde bornes d'entrée.

Selon un mode de mise en œuvre, le dispositif de précharge comprend des premier et second commutateurs de charge reliant les première et seconde entrées à un potentiel de masse quand ils sont rendus conducteurs sur commande d'un premier signal de précharge, et comprend également des troisième et quatrième commutateurs de charge, reliant les première et seconde grilles à une tension d'alimentation, quand ils sont rendus conducteurs sur commande d'un second signal de précharge, les premier et second signaux de précharge étant avantageusement concomitants.

Selon un mode de mise en œuvre, le dispositif de partage comprend des premier et second commutateurs de partage commandés et destinés à court-circuiter la grille et le drain de chacun des premier et second transistors sur commande d'un signal de partage, les troisième et quatrième commutateurs de charge étant non conducteurs lors de la phase de partage.

Selon un mode de mise en œuvre, le dispositif de décision comprend des premier et second commutateurs d'entrée commandés et destinés à appliquer les premier Vᵢₙ₁ et second Vᵢₙ₂ potentiels d'entrée sur les première et seconde entrées sur commande d'un signal de décision, ledit signal de décision commandant également la fermeture des premier et second commutateurs de décision de manière à permettre le passage d'un courant à travers l'étage différentiel et l'étage de décision, les commutateurs de partage et les commutateurs de charge étant non conducteurs pendant la phase de décision.

Selon un mode de mise en œuvre, l'étage de décision et l'étage différentiel sont placés en série entre une masse et une tension d'alimentation, le nœud S de l'étage différentiel étant relié à la masse, soit directement, soit par l'intermédiaire d'un transistor d'activation, le transistor d'activation étant rendu conducteur lors de la phase de décision.

Selon un mode de mise en œuvre, le nœud S de l'étage différentiel est relié à la masse par l'intermédiaire d'un transistor d'activation et dans lequel un troisième condensateur est placé entre la masse et un troisième commutateur de partage relié par ailleurs au nœud S, un commutateur de réinitialisation étant placé en parallèle du troisième condensateur, le troisième condensateur étant déchargé en rendant conducteur le commutateur de réinitialisation lors de la phase de précharge, le troisième condensateur étant relié au nœud S en rendant conducteur le troisième commutateur de partage (CP3) lors de la phase de partage.

Selon un mode de mise en œuvre, le transistor d'activation est rendu conducteur lors de la phase de partage des charges pour permettre le transfert de charges des première et seconde grilles vers le point S.

Selon un mode de mise en œuvre, le comparateur comprend en outre des premier et second commutateurs d'entrée reliés respectivement aux première et secondes entrées et commandés pour être rendus conducteurs lors de la phase de décision.

Selon un mode de mise en œuvre, le comparateur comprend en outre un générateur de tension de référence destiné à imposer le second potentiel d'entrée Vᵢₙ₂.

Selon un mode de mise en œuvre, le générateur de tension de référence comprend un quatrième condensateur placé entre la masse et un nœud B ainsi qu'un cinquième condensateur placé entre la masse et un point C, un commutateur étant placé en parallèle du condensateur entre le nœud B et la masse, un commutateur étant placé entre le nœud B et un point C, un commutateur étant placé entre le point C et la tension d'alimentation Vdd, le commutateur étant placé entre le nœud B et l'entrée In2, les commutateurs étant commandés pour :
- lors de la phase de précharge, charger le condensateur à la tension Vdd et décharger le condensateur ;
- lors de la phase de partage, partager les charges entre les condensateurs, pour obtenir une tension de référence aux bornes des condensateurs ; et
- lors de la phase de décision, rendre conducteur le commutateur pour appliquer la tension de référence sur la seconde entrée.

Selon un mode de mise en œuvre, le comparateur est un comparateur à logique dynamique.

Selon un mode de mise en œuvre, l'étage de décision comprend deux inverseurs, dits, respectivement, premier inverseur et second inverseur, montés en contre-réaction.

Selon un mode de mise en œuvre, les sources des transistors NMOS des premier et second inverseurs sont connectées, respectivement, aux drains des premier et second transistors.

L'invention concerne également un imageur comprenant au moins un comparateur selon la présente invention.

### BRÈVE DESCRIPTION DES DESSINS

D'autres caractéristiques et avantages apparaîtront dans la description qui va suivre du comparateur compensé selon l'invention, donnés à titre d'exemples non limitatifs, en référence aux dessins annexés dans lesquels :
- la figure 1 est une représentation schématique d'un comparateur, plus particulièrement d'un comparateur dynamique, connu de l'état de la technique ;
- la figure 2 est une représentation schématique d'un comparateur compensé selon un mode de réalisation de la présente invention, en particulier l'étage de décision, qui n'est donné qu'à titre d'exemple, est celui d'un comparateur dynamique ;
- la figure 3 est une représentation schématique du comparateur compensé reprenant tous les éléments du comparateur de la figure 2, en particulier, la figure 3 représente l'état du compensateur pendant la phase de précharge ;
- la figure 4 est une représentation schématique du comparateur compensé reprenant tous les éléments du comparateur de la figure 2, en particulier, la figure 4 représente l'état du compensateur pendant la phase de partage ;
- la figure 5 est une représentation schématique du comparateur compensé reprenant tous les éléments du comparateur de la figure 2, en particulier, la figure 5 représente l'état du compensateur pendant la phase de décision.

### EXPOSÉ DÉTAILLÉ DE MODES DE RÉALISATION PARTICULIERS

La présente invention concerne un comparateur compensé. Notamment, la présente invention concerne un comparateur qui comprend un étage de décision et un étage différentiel pourvu de deux transistors reliés par leur source.

L'étage différentiel est pourvu de moyens de compensation destinés à compenser les effets d'une dispersion des tensions de seuil des transistors formant l'étage différentiel.

Notamment, les moyens de compensation comprennent des premier et second condensateurs, chacun placé entre une grille d'un des deux transistors et une des deux entrées du comparateur. Comme cela sera détaillé ci-après, les condensateurs permettent dans une phase initiale, pré-décision, de « mémoriser » une tension à leurs bornes qui est fonction de la tension de seuil du transistor associé (et qui tient compte de son éventuel décalage par rapport à une valeur nominale). Dans une phase de décision, les potentiels à comparer sont appliqués sur les entrées du comparateur et sont ensuite transmis sur les grilles des transistors, avec un décalage de tension correspondant aux tensions mémorisées dans les condensateurs.

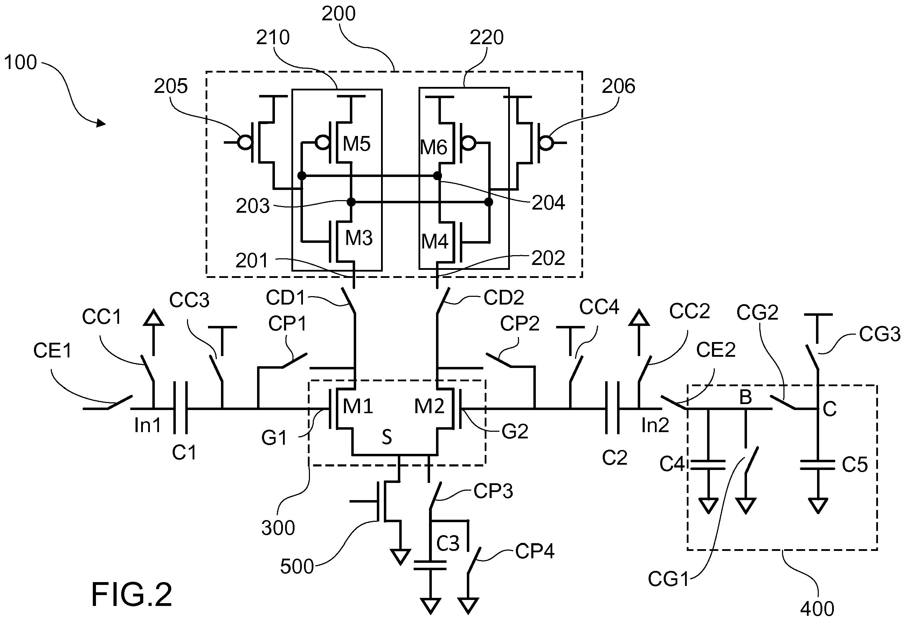

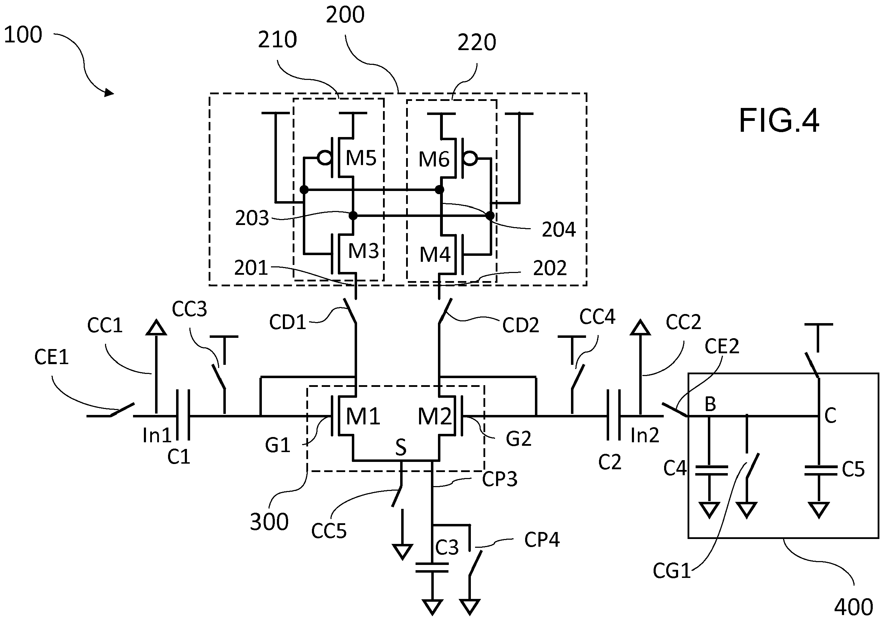

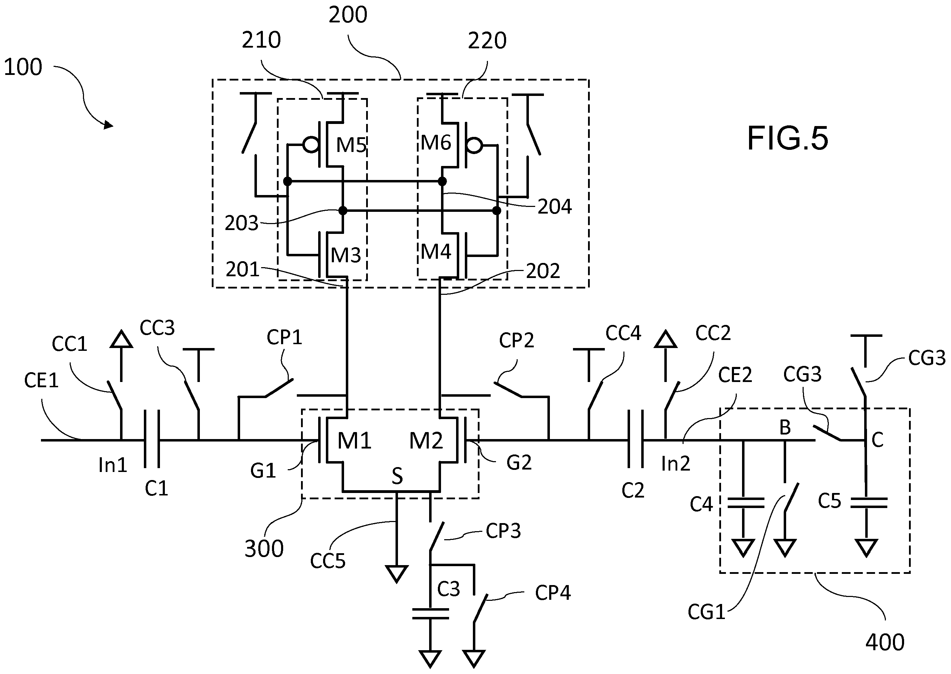

Sur les figures 2 à 5, on peut voir un exemple de comparateur compensé 100 selon un mode de réalisation de la présente invention.

Le comparateur compensé 100 comprend un étage de décision 200, un étage différentiel 300 et un étage d'activation (représenté dans cet exemple par un transistor d'activation 500), placés tous trois en série entre une tension d'alimentation Vdd et une masse.

Le comparateur 100 est destiné à comparer un premier potentiel Vᵢₙ₁ et un second potentiel Vᵢₙ₂, imposés respectivement sur une première entrée In1 et une seconde entrée In2 du comparateur compensé 100.

Le comparateur représenté aux figures 2 à 5 est un comparateur réalisé en logique dynamique, avec un circuit de contrôle non représenté fonctionnant avec une phase de précharge et une phase d'évaluation (ou décision). Un tel comparateur est particulièrement adapté à un fonctionnement basse consommation.

L'étage de décision 200 comprend deux inverseurs CMOS montés en contre-réaction et dits, respectivement, premier inverseur 210 et second inverseur 220. Ces deux inverseurs sont placés entre une tension d'alimentation Vdd et l'étage différentiel.

En particulier, le premier inverseur 210 comprend un transistor NMOS M3 et un transistor PMOS M5 ayant leurs drains reliés en un nœud 203, la source du transistor M3 formant une première borne d'entrée 201 de l'étage de décision 200. De manière équivalente, le second inverseur 220 comprend un transistor NMOS M4 et un transistor PMOS M6 ayant leurs drains reliés en un nœud 204, la source du transistor M4 formant une seconde borne d'entrée 202 de l'étage de décision 200.

L'étage de décision 200 comprend en outre deux transistors de précharge 205 et 206 reliés respectivement aux entrées des inverseurs, c'est-à-dire aux nœuds 204 et 203.

L'étage différentiel 300 comprend deux transistors de même type, un premier transistor M1 et un second transistor M2 ayant leurs sources reliées en un nœud S, et pourvus chacun d'une grille dite, respectivement, première grille G1 et seconde grille G2.

Les premier M1 et second M2 transistors, de tensions de seuil respectives Vₜₕ₁ et Vₜₕ₂, sont du même type, soit de type p (dit transistor PMOS) soit de type n (dit transistor NMOS).

Dans la suite de l'énoncé, les premier M1 et second M2 transistors sont considérés comme étant de type n (NMOS).

Comme tout comparateur fonctionnant en logique dynamique avec une phase de précharge et une phase d'évaluation (ou décision), les transistors de précharge 205 et 206 sont rendus conducteurs pendant la phase de précharge et le transistor d'évaluation 500 est quant à lui rendu conducteur dans la phase de décision. Ainsi, pendant la phase de précharge, les deux entrées des inverseurs sont maintenues à la tension d'alimentation Vdd, et aucun courant ne traverse les étages en série car le transistor d'activation 500 est non conducteur, la consommation statique étant très faible. Pendant la phase de décision, les transistors de précharge 205 et 206 sont non conducteurs et le transistor d'activation 500 est rendu conducteur, ce qui induit une circulation de courant à travers la série d'étages. Les courants traversant les transistors M1 et M2 sont fonction des tensions sur leurs grilles et les deux inverseurs 210 et 220 « basculent » dans un sens ou dans un autre entrainant une tension basse (proche de la masse) sur le point 203 et une tension haute (Vdd) sur le point 204 ou inversement. Une fois le basculement réalisé, la décision prise peut être relevée par un dispositif extérieur, non représenté, connecté à une ou des sorties du comparateur correspondant aux points 203 et 204.

De façon générale, par « commutateur commandé » , on entend un commutateur qui, sous l'effet d'un signal approprié, commute entre deux états dits, respectivement, passant et non passant. Un commutateur commandé peut comprendre un transistor de type n ou p commutant entre un état passant et un état non passant en fonction de son potentiel de grille.

Selon un aspect de la présente invention, le comparateur compensé 100 comprend également un premier condensateur C1 et un second condensateur C2 intercalés, respectivement, entre la première grille G1 et la première entrée In1 et entre la seconde grille G2 et la seconde entrée In2.

Le comparateur compensé 100 comprend également un dispositif de précharge MCi, un dispositif de partage de charges MPi, et un dispositif de décision MDi destinés à être mis en œuvre, respectivement, lors de phases successives de précharge, de partage et de décision.

De manière générale, le dispositif de précharge MCi, le dispositif de partage des charges MPi et le dispositif de décision MDi correspondent tout trois à un agencement particulier, notamment un agencement de commutateurs commandés, et mis en œuvre lors des différentes phases successives de précharge, de partage et de décision.

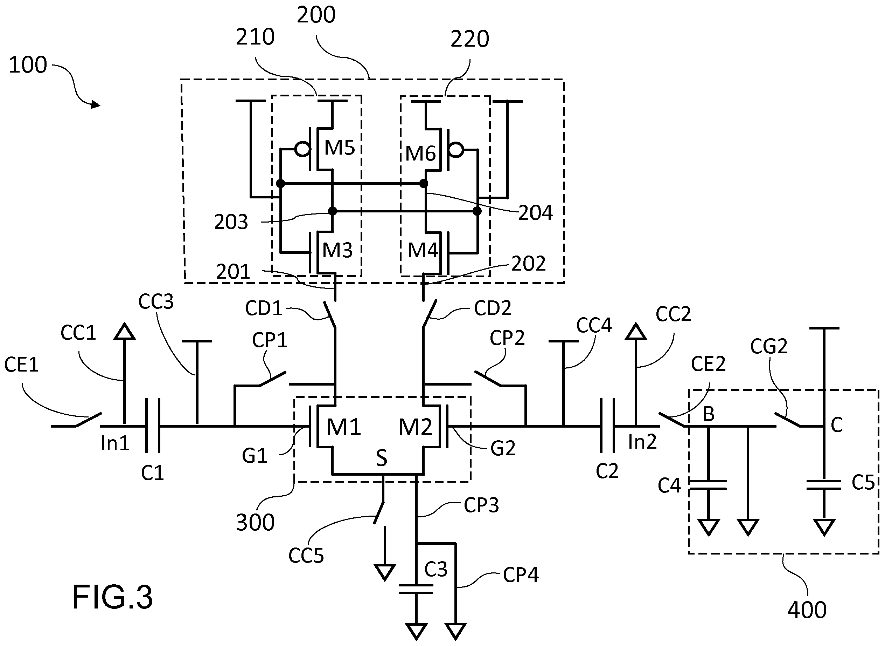

A cet égard, les figures 3, 4 et 5 correspondent à trois états de commutation de l'agencement de commutateurs commandés. Notamment, les figures 3, 4 et 5 illustrent le rôle de l'agencement de commutateurs commandés lors des phases, respectivement, de précharge, de partage et de décision.

Les différents dispositifs (précharge, partage, décision) sont commandés par un circuit de contrôle, non représenté, qui commande l'ensemble des commutateurs présents dans ces dispositifs. Le circuit de contrôle utilise par exemple un signal d'horloge pour cadencer les différentes phases de son fonctionnement.

Pendant les phases initiales, précédent l'étape de décision, l'étage de décision et l'étage différentiel sont isolés pour ne pas perturber le fonctionnement des dispositifs de précharge et de partage décrits plus en détails ci-après. Ainsi, les drains des transistors M1 et M2 de l'étage différentiel sont reliés aux bornes d'entrée 201 et 202 de l'étage de décision 200 par des commutateurs CD1 et CD2. Ces commutateurs CD1 et CD2 sont rendus conducteurs uniquement pendant la phase de décision.

Le dispositif de précharge MCi permet de charger le premier condensateur C1 et le second condensateur C2 de sorte à avoir une tension de précharge Vprech aux bornes de chaque condensateur en fin de phase de précharge.

Le dispositif de précharge MCi comprend un premier commutateur de charge CC1 et un second commutateur de charge CC2 permettant de relier à un potentiel de masse, respectivement la première entrée In1 et la seconde entrée In2.

Le dispositif de précharge MCi comprend également un troisième commutateur de charge CC3 et un quatrième commutateur de charge CC4 permettant de relier la source de tension Vdd, respectivement à la première grille G1 et à la seconde grille G2.

Les premier CC1, second CC2, troisième CC3 et quatrième CC4 commutateurs de charge sont commandés par le circuit de contrôle pour être passants lors de la phase de précharge.

Le premier commutateur de charge CC1 et le second commutateur de charge CC2 commutent dans un état passant, au début de la phase de précharge, sous l'effet d'un premier signal de charge, de manière à imposer un potentiel de masse au niveau de la première entrée In1 et de la seconde entrée In2.

Le troisième commutateur de charge CC3 et le quatrième commutateurs de charge CC4 commutent dans un état passant au début de la phase de précharge sous l'effet d'un second signal de charge, de manière à imposer le potentiel Vdd, respectivement à la première grille G1 et à la seconde grille G2.

Le premier signal de charge et le second signal de charge peuvent être concomitants.

A l'issue de la phase de précharge, la tension Vprech aux bornes de chacun des premier C1 et second C2 condensateurs est dans cet exemple égale à la tension Vdd. La tension de précharge Vprech des condensateurs pourraient être différente de Vdd. Sa valeur doit être suffisante pour permettre de réaliser l'étape suivante.

La phase de précharge est alors suivie d'une phase de partage qui met en œuvre le dispositif de partage MPi.

Le dispositif de partage MPi est prévu pour court-circuiter la première grille G1 avec le drain du premier transistor M1, et la seconde grille G2 avec le drain du second transistor M2.

Le premier transistor M1 et le second transistor M2 sont initialement conducteurs et il s'effectue un transfert de charges entre le premier condensateur C1 et la source S d'une part, et entre le second condensateur C2 et la source S d'autre part. Ce transfert de charges résulte de l'écoulement des charges des condensateurs C1 et C2 au travers des canaux des transistors M1 et M2 passants vers le nœud S de potentiel plus faible. Cette variation décroissante du potentiel, respectivement, sur la première grille G1 et la seconde grille G2 aboutit à la commutation d'un état passant à un état non passant des premier M1 et second M2 transistors.

Afin que cet écoulement de charges soit possible, il est nécessaire au début de la phase de partage, que le potentiel du nœud S soit suffisamment bas pour que les transistors M1 et M2 soient conducteurs. Autrement dit, la tension grille-source (Vg1s et Vg2s) des transistors M1 et M2 doit être supérieure aux tensions de seuil respectives des transistors. Si on note Vs la tension au nœud S, on a pendant la phase de partage la relation suivante entre les tensions : Vs +Vg1s = V1 et Vs +Vg2s = V2, avec V1 et V2 les tensions respectivement aux bornes des condensateurs C1 et C2. La tension Vs peut varier ou non au cours de la phase de partage selon les modes de réalisation. Quoi qu'il en soit, la tension initiale Vsi au nœud S et les tensions initiales V1i et V2i sont telles que V1i-Vsi > Vth1 et V2i-Vsi > Vth2. Après écoulement des charges, les transistors M1 et M2 se bloquent et les tensions aux bornes des condensateurs sont alors sensiblement les suivantes : Vsf +Vth1 = V1 et Vsf +Vth2 = V2, avec Vsf égal à la tension finale au nœud S après partage des charges (Vsf pouvant être égal ou différent de Vsi selon le mode de réalisation). Ainsi, si les tensions de seuil des transistors diffèrent, les tensions aux bornes des condensateurs sont également différentes en fin de phase de partage, préalablement à la phase de décision.

Selon un mode de réalisation, le dispositif de charge MCi comprend un cinquième commutateur de charge CC5 commandé pour, dès lors qu'il est passant, connecter la source S au potentiel de masse lors des phases de précharge et de partage. La fonction du commutateur de charges CC5 peut éventuellement être réalisée par le commutateur 500.

Selon un mode de réalisation, le dispositif de partage MPi comprend un premier commutateur de partage CP1 et un second commutateur de partage CP2 permettant de court-circuiter la grille et le drain, respectivement, du premier transistor M1 et du second transistor M2 lors de la phase de partage. Les commutateurs CP1 et CP2 sont de préférence non conducteurs pendant la phase de précharge (des condensateurs C1 et C2) pour éviter toute consommation d'énergie inutile et permettre une charge rapide des condensateurs C1 et C2. Les commutateurs CP1 et CP2 sont non conducteurs pendant la phase de décision.

Le premier commutateur de partage CP1 et le second commutateur de partage CP2 commutent dans un état passant au début de la phase de partage sous l'effet d'un signal de partage de manière à court-circuiter, la grille et le drain, respectivement, du premier transistor M1 et du second transistor M2.

Un signal de commande, concomitant avec le signal de partage, ou précédant le signal de partage, commande la commutation dans un état non passant du troisième commutateur de charge CC3 et du quatrième commutateur de charge CC4, afin de ne pas perturber l'écoulement des charges.

Lors de la phase de partage, le premier commutateur de charge CC1 et le second commutateur de charge CC2 sont maintenus dans un état passant afin de permettre une décharge des condensateurs C1 et C2 jusqu'à ce que les transistors M1 et M2 soient non conducteurs.

Selon une première variante, la source S est maintenue au potentiel de masse pendant toute la durée de la phase de partage.

Selon une seconde variante, le dispositif de partage MPi comprend en outre un troisième condensateur C3 intercalé entre la masse et le nœud S. Un troisième commutateur de partage CP3 est intercalé entre le nœud S et le condensateur C3. Un quatrième commutateur de réinitialisation CP4 est placé en parallèle du condensateur C3, entre la masse et le point de liaison du commutateur CP3 et du condensateur C3. Lors de la phase de précharge, le condensateur C3 est réinitialisé en rendant conducteur le commutateur CP4 (CP4 étant non conducteur lors des autres phases). Lors de la phase de partage, le commutateur CP3 est rendu conducteur, de sorte que le partage de charges s'effectue entre le premier condensateur C1 et le troisième condensateur C3 d'une part, et le second condensateur C2 et le troisième condensateur C3 d'autre part.

La phase de partage est suivie de la phase de décision au cours de laquelle l'étage de décision délivre un signal de sortie qui est fonction des potentiels d'entrée Vᵢₙ₁ et Vᵢₙ₂ imposés, respectivement, à la première entrée In1 et à la seconde entrée In2.

Selon un mode de réalisation, un premier commutateur d'entrée CE1 et un second commutateur d'entrée CE2 sont reliés respectivement à la première entrée In1 et à la seconde entrée In2. Lors de la phase de décision, les commutateurs CE1 et CE2 sont rendus passants et des premier Vᵢₙ₁ et second Viₙ₂ potentiels d'entrée sont appliqués sur les entrées In1 et In2.

En outre, durant la phase de décision, le premier commutateur de décision CD1 et le second commutateur de décision CD2 sont rendus conducteurs, ainsi que le transistor d'activation 500. Les 3 étages en série (décision 200, différentiel 300 et activation 500) sont activés, et un courant circule entre la tension d'alimentation et la masse à travers les inverseurs 210, 220, les transistors M1, M2 et le transistor 500. Cette phase de décision correspond à la phase d'évaluation d'un comparateur en logique dynamique telle que précédemment expliqué. Les potentiels des sorties 203 et 204 s'établissent en fonction des potentiels présents sur les grilles G1 et G2..

Dans le comparateur selon la présente invention, les tensions appliquées sur les grilles G1 et G2 lors de la phase de décision ne sont pas directement les tensions Vin1 et Vin2 que l'on souhaite comparer. En effet, suite aux deux phases préalables de précharge et de partage, les condensateurs C1 et C2 sont chargés et présentent des tensions à leurs bornes respectivement Vsf +Vth1 = V1 et Vsf +Vth2 = V2 comme décrit précédemment. Au moment où la tension Vin1 est appliquée sur l'entrée In1, l'entrée In1 passe d'un potentiel sensiblement nul (car entrée In1 précédemment reliée à la masse) à la tension Vin1. Par suite, le potentiel sur la grille G1 est également décalé et passe de Vsf +Vth1 à Vsf+Vth1+Vin1. De façon similaire, le potentiel sur la grille G2 est également décalé et passe de Vsf +Vth2 à Vsf +Vth2+Vin2.

Le potentiel du nœud S est sensiblement nul pendant la phase de décision, lorsque le commutateur 500 est rendu conducteur. Ainsi, les tensions Vg1s et Vg2s sont définies par : Vgls= Vsf +Vth1+Vin1 et Vg2s = Vsf +Vth2+Vin2.

Dans le cas tel que représenté en figure 2 où on utilise un condensateur C3 (avec les commutateurs associés CP3 et CP4), la tension Vsf est non nulle et est avantageusement choisie (par dimensionnement relatif des condensateurs C3 et C1/C2) de sorte que les tensions Vg1s et Vg2s susmentionnées soient significativement supérieures aux tensions de seuil Vth1 et Vth2 de sorte que les transistors M1 et M2 sont bien conducteurs pendant la phase de décision. Cela permet d'améliorer la précision de la comparaison, ainsi que la rapidité de prise de décision. Il est ainsi possible de réaliser la prise de décision rapidement et par suite de diminuer la consommation dynamique du comparateur. Ce mode de réalisation est en outre particulièrement adapté au cas où les tensions Vin1 et Vin2 sont faibles, voire très faibles et ne suffisent pas à elles seules à rendre bien conducteurs les transistors M1 et M2.

Comme décrit précédemment, durant la phase de décision, les premier CP1 et second CP2 commutateurs de partage ainsi que les commutateurs de charge CC1, CC2, CC3 et CC4 sont non conducteurs.

Il résulte de cette phase de décision, la génération d'un état, dit état final, à la ou aux bornes de sortie du comparateur compensé 100, correspondant aux nœuds 203 et 204.

L'état final sur une borne de sortie peut prendre deux valeurs dites, respectivement, état haut et état bas, qui dépend du signe de la différence Vᵢₙ₁ - Vᵢₙ₂.

Les moyens mis en œuvre dans le cadre de la présente invention, et en particulier le dispositif de précharge MCi et le dispositif de partage MPi consomment peu d'énergie et ne rajoute que très peu de consommation par rapport au comparateur en logique dynamique classique.

En particulier, un comparateur compensé, noté ci-après « comparateur test », fabriqué selon le nœud technologique de 130 nm et pourvu de capacités C1 et C2 de 35 fF et d'une capacité C3 de 600 fF ne consomme que 250 nW à 10 MHz.

L'avantage principal des dispositifs de précharge MCi et de partage MPi est qu'ils permettent de compenser les variations technologiques des transistors du comparateur, notamment celles des transistors M1 et M2. La dispersion du point de basculement d'un comparateur à l'autre est ainsi fortement réduite.

Selon une simulation exécutée sur le comparateur test, la solution apportée par la présente invention permet de réduire la dispersion et de passer de 50mV à 2,5 mV de dispersion (à ±3 σ), pour une tension d'alimentation de 1V.

En outre, dans le cas où la fréquence d'utilisation du comparateur n'impose pas d'enchaîner rapidement les 3 phases, il est possible de faire durer le plus longtemps possible l'étape de précharge MCi (qui présente une très faible consommation statique) et de réaliser l'étape de partage MPi juste avant de réaliser l'étape de décision. Ainsi, l'étape de partage MPi qui permet de « mémoriser » le différentiel de tensions de seuil Vth1 / Vth2 dans les condensateurs C1 et C2 pourra mémoriser les conditions « présentes » de variations dues au vieillissement des composants, à la température... et non seulement aux dispersions initiales de procédé de fabrication.

En outre, le comparateur compensé 100 peut également comprendre un générateur de tension de référence 400 pour délivrer le second potentiel d'entrée Vᵢₙ₂.

Selon un mode de réalisation, le générateur 400 comprend un quatrième condensateur C4 placé entre la masse et un nœud B ainsi qu'un cinquième condensateur C5 placé entre la masse et un point C. Un commutateur CG1 est placé en parallèle du condensateur C4, entre le nœud B et la masse. Un commutateur CG2 est placé entre le nœud B et le point C. Un commutateur CG3 est placé entre le point C et la tension d'alimentation Vdd. Le commutateur CE2 est placé entre la borne B et l'entrée In2.

Le générateur 400 est par exemple commandé par le circuit de contrôle pour :
- lors de la phase de précharge, isoler les deux condensateurs C4, C5 en rendant non conducteur CG2, puis charger le condensateur C5 à la tension d'alimentation Vdd en rendant passant le commutateur CG3, et décharger le condensateur C4, en rendant conducteur le commutateur CG1 ;
- lors de la phase de partage, isoler le condensateur C5 de la source de tension Vdd (en rendant non conducteur le commutateur CG3), puis rendre non conducteur le commutateur CG1 et réaliser un partage des charges entre C4 et C5 en rendant conducteur le commutateur CG2 - à l'issue du partage de charge, le potentiel au niveau borne B correspond au potentiel de référence que l'on souhaite appliquer comme tension Vᵢₙ₂ ;
- lors de la phase de décision, isoler le condensateur C5 si l'on souhaite pouvoir commencer à recharger C5 à la tension Vdd et imposer le potentiel de référence présent sur le condensateur C4 sur l'entrée In2.

Un avantage du générateur de tension de référence décrit ci-dessus est qu'il est réalisé selon les principes de la logique dynamique avec une consommation minimale. Dans les applications pour lesquelles le comparateur est utilisé pour comparer un signal, Vin1, à une tension de référence appliquée sur Vin2, on pourra avantageusement réaliser un ensemble comparateur/générateur qui soit très basse consommation.

Un tel ensemble peut avantageusement être utilisé dans un capteur d'images pour réaliser une mesure de la valeur de tension correspondant à un pixel par comparaison à une référence de tension.

D'autres modes de réalisation de la présente invention peuvent être envisagés. Entre autre, d'autres schémas de comparateur peuvent être utilisés, l'invention n'étant pas limitée à l'exemple de comparateur en logique dynamique décrit précédemment. Par exemple, l'étage de décision peut correspondre à une simple charge résistive, chacun des nœuds 201 et 202 étant alors relié à une résistance connectée par ailleurs à la tension d'alimentation Vdd. D'autres types de charge peuvent être envisagées pour intégrer par exemple des fonctions de filtrage ou d'autres fonctions de limitation de la consommation. En outre, l'étage d'activation relié à la source des transistors M1 et M2 est bien entendu adaptée au type de charge choisie pour réaliser l'étage de décision, comme cela est bien connu de l'homme de l'art. Par exemple, dans le cas où deux résistances sont utilisées pour l'étage de décision, une source de courant peut être placée entre le nœud S de l'étage 300 et la masse.

Par ailleurs, l'homme de l'art pourra aisément réaliser les circuits décrits précédemment en logique complémentaire, en utilisant des transistors de type P pour l'étage différentiel.

### REFERENCES

[1] Miyahara, M & Asada, Yusuke & Paik, Daehwa & Matsuzawa, Akira. (2008), « A low-noise self-calibrating dynamic comparator for high-speed ADCs » ; 269-272, 10.1109/ASSCC.2008.4708780.
[2] Cui, Ji & Tani, Sadahiro & Ohara, Kenji & Hirai, Yusaku & Matsuoka, Toshimasa. (2015), « A dynamic latched comparator with built-in offset calibration », Far East Journal of Electronics and Communications. 14. 105-115. 10.17654/FJECJun2015_105_115.

## Revendications

1. Comparateur compensé (100) comprenant :
- des première (In1) et seconde (In2) entrées destinées à recevoir respectivement des premier Vin1 et second Vin2 potentiels à comparer ;
- un étage différentiel (300) doté de premier (M1) et second (M2) transistors de même type, reliés par leurs sources en un nœud S et comprenant chacun une grille dite, respectivement, première (G1) et seconde (G2) grille,
- un étage de décision (200) relié aux drains des premier et second transistors et délivrant un signal de comparaison sur une sortie du comparateur (203, 204) ;
**caractérisé en ce qu'**il comprend
- des premier (C1) et second (C2) condensateurs intercalés, respectivement, entre la première grille (G1) et la première entrée (In1) et entre la seconde grille (G2) et la seconde entrée (In2),
- des premier (CD1) et second (CD2) commutateurs de décision placés entre l'étage de décision (200) et les drains des premier et second transistors de l'étage différentiel ;
- des dispositifs de précharge (MCi), de partage (MPi), et de décision (MDi) commandés par un circuit de contrôle, pour mettre en œuvre des phases successives de précharge, de partage et de décision,
le dispositif de précharge (MCi) permettant d'imposer une charge aux premier (C1) et second (C2) condensateurs de sorte qu'une tension de précharge (Vprech) soit présente aux bornes des condensateurs en fin de phase de précharge,
le dispositif de partage (MPi) permettant de court-circuiter la grille et le drain de chacun des premier (M1) et second (M2) transistors, les courts-circuits provoquant un transfert de charge des premier (C1) et second (C2) condensateurs vers le nœud S, le transfert s'interrompant dès lors que les tensions grille-source des premier (M1) et second (M2) transistors deviennent inférieures aux tensions de seuil respectives des premier et second transistors, et
le dispositif de décision (MDi) permettant de rendre passants lesdits commutateurs de décision pour réaliser la comparaison entre les premier et second potentiels d'entrée appliqués sur les première et seconde bornes d'entrée.

2. Comparateur selon la revendication 1, dans lequel le dispositif de précharge (MCi) comprend des premier (CC1) et second (CC2) commutateurs de charge reliant les première (In1) et seconde (In2) entrées à un potentiel de masse quand ils sont rendus conducteurs sur commande d'un premier signal de précharge, et comprend également des troisième (CC3) et quatrième (CC4) commutateurs de charge, reliant les première (G1) et seconde (G2) grilles à une tension d'alimentation (Vdd), quand ils sont rendus conducteurs sur commande d'un second signal de précharge, les premier et second signaux de précharge étant avantageusement concomitants.

3. Comparateur selon la revendication 2, dans lequel le dispositif de partage comprend des premier (CP1) et second (CP2) commutateurs de partage commandés et destinés à court-circuiter la grille (G1, G2) et le drain de chacun des premier (M1) et second (M2) transistors sur commande d'un signal de partage, les troisième (CC3) et quatrième (CC4) commutateurs de charge étant non conducteurs lors de la phase de partage.

4. Comparateur selon la revendication 3, dans lequel le dispositif de décision comprend des premier (CE1) et second (CE2) commutateurs d'entrée commandés et destinés à appliquer les premier Vᵢₙ₁ et second Vᵢₙ₂ potentiels d'entrée sur les première (In1) et seconde (In2) entrées sur commande d'un signal de décision, ledit signal de décision commandant également la fermeture des premier (CD1) et second (CD2) commutateurs de décision de manière à permettre le passage d'un courant à travers l'étage différentiel et l'étage de décision (200), les commutateurs de partage et les commutateurs de charge étant non conducteurs pendant la phase de décision.

5. Comparateur selon l'une des revendications 1 à 4, dans lequel l'étage de décision et l'étage différentiel sont placés en série entre une masse et une tension d'alimentation (Vdd), le nœud S de l'étage différentiel étant relié à la masse, soit directement, soit par l'intermédiaire d'un transistor d'activation (500), le transistor d'activation étant rendu conducteur lors de la phase de décision.

6. Comparateur selon la revendication 5, dans lequel le point S de l'étage différentiel est relié à la masse par l'intermédiaire d'un transistor d'activation (500) et dans lequel un troisième condensateur (C3) est placé entre la masse et un troisième commutateur de partage (CP3) relié par ailleurs au nœud S, un commutateur de réinitialisation (CP4) étant placé en parallèle du troisième condensateur (C3), le troisième condensateur étant déchargé en rendant conducteur le commutateur de réinitialisation lors de la phase de précharge, le troisième condensateur étant relié au nœud S en rendant conducteur le troisième commutateur de partage (CP3) lors de la phase de partage.

7. Comparateur selon la revendication 5, dans lequel le transistor d'activation est rendu conducteur lors de la phase de partage des charges pour permettre le transfert de charges des première et seconde grilles (G1, G2) vers le nœud S.

8. Comparateur selon l'une des revendications 1, comprenant en outre des premier et second commutateurs d'entrée (CE1, CE2) reliés respectivement aux première et secondes entrées et commandés pour être rendus conducteurs lors de la phase de décision.

9. Comparateur selon l'une des revendications 1 à 8, dans lequel le comparateur (100) comprend en outre un générateur de tension de référence (400) destiné à imposer le second potentiel d'entrée Vᵢₙ₂.

10. Comparateur selon les revendications 8 et 9, dans lequel le générateur de tension de référence (400) comprend un quatrième (C4) condensateur placé entre la masse et un nœud B ainsi qu'un cinquième condensateur (C5) placé entre la masse et un point C, un commutateur (CG1) étant placé en parallèle du condensateur C4 entre le nœud B et la masse, un commutateur (CG2) étant placé entre le nœud B et un point C, un commutateur (CG3) étant placé entre le point C et la tension d'alimentation Vdd, le commutateur (CE2) étant placé entre le nœud B et l'entrée In2, les commutateurs (CG1, CG2 et CG3) étant commandés pour :
- lors de la phase de précharge, charger le condensateur (C5) à la tension Vdd et décharger le condensateur (C4) ;
- lors de la phase de partage, partager les charges entre les condensateurs (C4, C5), pour obtenir une tension de référence aux bornes des condensateurs ; et
- lors de la phase de décision, rendre conducteur le commutateur (CG2) pour appliquer la tension de référence sur la seconde entrée (In2).

11. Comparateur selon l'une des revendications 1 à 10, dans lequel le comparateur est un comparateur à logique dynamique.

12. Comparateur selon la revendication 11, dans lequel l'étage de décision (200) comprend deux inverseurs, dits, respectivement, premier inverseur (210) et second inverseur (220), montés en contre-réaction.

13. Comparateur selon la revendication 12, dans lequel les sources des transistors NMOS des premier et second inverseurs sont connectées, respectivement, aux drains des premier (M1) et second (M2) transistors.

14. Imageur comprenant au moins un comparateur selon l'une des revendications 1 à 13.

## Patentansprüche

1. Kompensierter Komparator (100), umfassend:
- Einen ersten (In1) und zweiten (In2) Eingang, welcher für die Aufnahme des ersten Vin1- bzw. zweiten Vin2-Potenzials, die verglichen werden sollen, ausgebildet ist;
- eine Differenzialstufe (300), welche mit einem ersten (M1) und einem zweiten (M2) Transistor desselben Typs versehen ist, welche mit ihren Sourcen an einem Knotenpunkt S verbunden sind und jeweils ein sogenanntes erstes (G1) bzw. zweites (G2) Gate aufweisen,
- eine Entscheidungsstufe (200), die mit den Drains des ersten und des zweiten Transistors verbunden ist und ein Vergleichssignal an einem Ausgang des Komparators (203, 204) liefert;
**dadurch gekennzeichnet, dass** sie umfasst:
- einen ersten (C1) und einen zweiten (C2) Kondensator, jeweils eingefügt zwischen dem ersten Gate (G1) und dem ersten Eingang (In1) bzw. zwischen dem zweiten Gate (G2) und dem zweiten Eingang (In2),
- erste (CD1) und zweite (CD2) Entscheidungsschalter, die zwischen der Entscheidungsstufe (200) und den Drains des ersten und zweiten Transistors der Differenzialstufe angeordnet sind;
- Vorlade- (MCi), Verteilungs- (MPi) und Entscheidungsvorrichtungen (MDi), die von einer Steuerschaltung gesteuert sind, um aufeinanderfolgende Vorlade-, Verteilungs- und Entscheidungsphasen zu realisieren,
wobei es die Vorladevorrichtung (MCi) ermöglicht, an dem ersten (C1) und zweiten (C2) Kondensator eine Ladung anzulegen, so dass am Ende der Vorladephase an den Anschlüssen der Kondensatoren eine Vorladespannung (Vprech) vorhanden ist,
wobei es die Verteilungsvorrichtung (MPi) ermöglicht, das Gate und den Drain jedes ersten (M1) und zweiten (M2) Transistors kurzzuschließen, wobei die Kurzschlüsse einen Ladungstransfer von dem ersten (C1) und zweiten (C2) Kondensator zum Knoten S bewirken, wobei der Transfer unterbrochen ist, sobald die Gate-Source-Spannungen des ersten (M1) und zweiten (M2) Transistors niedriger werden als die jeweiligen Schwellenspannungen des ersten und zweiten Transistors, und
wobei es die Entscheidungsvorrichtung (MDi) ermöglicht, die Entscheidungsschalter anzuschalten, um den Vergleich zwischen dem ersten und dem zweiten Eingangspotential durchzuführen, die an dem ersten und dem zweiten Eingangsanschluss angelegt sind.

2. Komparator nach Anspruch 1, wobei die Vorladevorrichtung (MCi) einen ersten (CC1) und einen zweiten (CC2) Lastschalter aufweist, die den ersten (In1) und den zweiten (In2) Eingang mit einem Massepotential verbinden, wenn sie auf Befehl eines ersten Vorladesignals leitend gemacht sind, und ferner einen dritten (CC3) und einen vierten (CC4) Lastschalter aufweist, die das erste (G1) und das zweite (G2) Gate mit einer Versorgungsspannung (Vdd) verbinden, wenn sie auf Befehl eines zweiten Vorladesignals leitend gemacht sind, wobei das erste und das zweite Vorladesignal vorteilhafterweise gleichzeitig auftreten.

3. Komparator nach Anspruch 2, wobei die Verteilungsvorrichtung einen ersten (CP1) und zweiten (CP2) Verteilungsschalter umfasst, welche auf Befehl eines Verteilungssignals zum Kurzschließen des Gates (G1, G2) und des Drains jedes von erstem (M1) und zweitem (M2) Transistor gesteuert und ausgebildet sind, wobei der dritte (CC3) und vierte (CC4) Lastschalter während der Verteilungsphase nicht leitend sind.

4. Komparator nach Anspruch 3, wobei die Entscheidungsvorrichtung einen ersten (CE1) und zweiten (CE2) Eingangsschalter umfasst, die dazu gesteuert und ausgebildet sind, das erste und zweite Eingangspotential Vin1 und Vin₂ auf Befehl eines Entscheidungssignals an dem ersten (In1) und zweiten (In2) Eingang anzulegen, wobei das Entscheidungssignal auch das Schließen des ersten (CD1) und zweiten (CD2) Entscheidungsschalters steuert, so dass ein Strom durch die Differenzialstufe und die Entscheidungsstufe (200) fließen kann, wobei die Verteilungsschalter und die Lastschalter während der Entscheidungsphase nicht leitend sind.

5. Komparator nach einem der Ansprüche 1 bis 4, wobei die Entscheidungsstufe und die Differenzialstufe in Reihe zwischen einer Masse und einer Versorgungsspannung (Vdd) angeordnet sind, wobei der Knoten S der Differenzialstufe entweder direkt oder über einen Aktivierungstransistor (500) mit der Masse verbunden ist, wobei der Aktivierungstransistor während der Entscheidungsphase leitend gemacht ist.

6. Komparator nach Anspruch 5, wobei der Punkt S der Differenzialstufe über einen Aktivierungstransistor (500) mit der Masse verbunden ist und wobei ein dritter Kondensator (C3) zwischen der Masse und einem dritten Verteilungsschalter (CP3) angeordnet ist, welcher ferner mit dem Knoten S verbunden ist, wobei ein Rückstellschalter (CP4) parallel zum dritten Kondensator (C3) angeordnet ist, wobei der dritte Kondensator in der Vorladephase entladen ist, indem der Rückstellschalter in der Vorladephase leitend gemacht ist, wobei der dritte Kondensator in der Verteilungsphase mit dem Knoten S verbunden ist, indem der dritte Verteilungsschalter (CP3) in der Verteilungsphase leitend gemacht ist.

7. Komparator nach Anspruch 5, wobei der Aktivierungstransistor in der Ladungsverteilungsphase leitend gemacht ist, um die Übertragung von Ladungen von dem ersten und zweiten Gate (G1, G2) zu dem Knoten S zu ermöglichen.

8. Komparator nach Anspruch 1, umfassend ferner einen ersten und einen zweiten Eingangsschalter (CE1, CE2), die mit dem ersten bzw. zweiten Eingang verbunden sind und so gesteuert sind, dass sie in der Entscheidungsphase leitend gemacht sind.

9. Komparator nach einem der Ansprüche 1 bis 8, wobei der Komparator (100) ferner einen Referenzspannungsgenerator (400) zum Anlegen des zweiten Eingangspotentials Vᵢₙ₂ umfasst.

10. Komparator nach den Ansprüchen 8 und 9, wobei der Referenzspannungsgenerator (400) einen vierten Kondensator (C4) umfasst, der zwischen der Masse und einem Knoten B angeordnet ist und einen fünften Kondensator (CS) umfasst, der zwischen der Masse und einem Punkt C angeordnet ist, wobei ein Schalter (CG1) parallel zu dem Kondensator C4 zwischen dem Knoten B und der Masse angeordnet ist, wobei ein Schalter (CG2) zwischen dem Knoten B und einem Punkt C angeordnet ist, wobei ein Schalter (CG3) zwischen dem Punkt C und der Versorgungsspannung Vdd angeordnet ist, wobei der Schalter (CE2) zwischen dem Knoten B und dem Eingang In2 angeordnet ist, wobei die Schalter (CG1, CG2 und CG3) gesteuert sind, um:
- in der Vorladephase den Kondensator (C5) auf die Spannung Vdd aufzuladen und den Kondensator (C4) zu entladen;
- in der Verteilungsphase, die Ladungen zwischen den Kondensatoren (C4, C5) zu verteilen, um eine Referenzspannung an den Kondensatoranschlüssen zu erhalten; und
- in der Entscheidungsphase den Schalter (CG2) leitend zu machen, um die Referenzspannung an dem zweiten Eingang (In2) anzulegen.

11. Komparator nach einem der Ansprüche 1 bis 10, wobei der Komparator ein Komparator mit dynamischer Logik ist.

12. Komparator nach Anspruch 11, wobei die Entscheidungsstufe (200) zwei Inverter umfasst, die als erster Inverter (210) bzw. zweiter Inverter (220) bezeichnet werden und in Gegenkopplung geschaltet sind.

13. Komparator nach Anspruch 12, wobei die Sourcen der NMOS-Transistoren des ersten und zweiten Inverters mit den Drains des ersten (M1) bzw. zweiten (M2) Transistors verbunden sind.

14. Ein Bildwandler, der mindestens einen Komparator gemäß einem der Ansprüche 1 bis 13 umfasst.

## Claims

1. Compensated comparator (100) comprising:
- first (In1) and second (In2) inputs intended to receive respectively first Vin1 and second Vin2 potentials to be compared;
- a differential stage (300) provided with first (M1) and second (M2) transistors of same type, connected by their sources in a node S and each comprising a gate called, respectively, first (G1) and second (G2) gate;
- a decision stage (200) connected to the drains of the first and second transistors and delivering a comparison signal on an output of the comparator (203, 204);
**characterised in that** it comprises
- first (C1) and second (C2) capacitors intercalated, respectively, between the first gate (G1) and the first input (In1) and between the second gate (G2) and the second input (In2),
- first (CD1) and second (CD2) decision switches placed between the decision stage (200) and the drains of the first and second transistors of the differential stage;
- pre-charge (MCi), sharing (MPi), and decision (MDi) devices commanded by a control circuit, to implement successive pre-charge, sharing and decision phases,
the pre-charge device (MCi) making it possible to impose a charge on the first (C1) and second (C2) capacitors such that a pre-charge voltage (Vprech) is present at the terminals of the capacitors at the end of the pre-charge phase,
the sharing device (MPi) making it possible to short circuit the gate and the drain of each of the first (M1) and second (M2) transistors, the short circuits causing a charge transfer from the first (C1) and second (C2) capacitors to the node S, the transfer being interrupted from the moment that the gate-source voltages of the first (M1) and second (M2) transistors become lower than the respective threshold voltages of the first and second transistors, and
the decision device (MDi) making it possible to switch on said decision switches to make the comparison between the first and second input potentials applied on the first and second input terminals.

2. Comparator according to claim 1, in which the pre-charge device (MCi) comprises first (CC1) and second (CC2) charge switches connecting the first (In1) and second (In2) inputs to an earth potential when they are made conductive on command of a first pre-charge signal, and also comprises third (CC3) and fourth (CC4) charge switches, connecting the first (G1) and second (G2) gates to a supply voltage (Vdd), when they are made conductive on command of a second pre-charge signal, the first and second pre-charge signals being advantageously concomitant.

3. Comparator according to claim 2, in which the sharing device comprises first (CP1) and second (CP2) sharing switches commanded and intended to short circuit the gate (G1, G2) and the drain of each of the first (M1) and second (M2) transistors on command of a sharing signal, the third (CC3) and fourth (CC4) charge switches being non-conductive during the sharing phase.

4. Comparator according to claim 3, in which the decision devices comprises first (CE1) and second (CE2) input switches commanded and intended to apply the first Vᵢₙ₁ and second Vᵢₙ₂ input potentials on the first (In1) and second (In2) inputs on command of a decision signal, said decision signal also commanding the closing of the first (CD1) and second (CD2) decision switches so as to enable the passage of a current through the differential stage and the decision stage (200), the sharing switches and the charge switches being non-conductive during the decision phase.

5. Comparator according to one of claims 1 to 4, in which the decision stage and the differential stage are placed in series between an earth and a supply voltage (Vdd), the node S of the differential stage being connected to earth, either directly, or through an activation transistor (500), the activation transistor being made conductive during the decision phase.

6. Comparator according to claim 5, in which the point S of the differential stage is connected to earth through an activation transistor (500) and in which a third capacitor (C3) is placed between earth and a third sharing switch (CP3) furthermore connected to the node S, a reset switch (CP4) being placed in parallel with the third capacitor (C3), the third capacitor being discharged by making the reset switch conductive during the pre-charge phase, the third capacitor being connected to the node S by making the third sharing switch (CP3) conductive during the sharing phase.

7. Comparator according to claim 5, in which the activation transistor is made conductive during the charge sharing phase to enable the transfer of charges from the first and second gates (G1, G2) to the node S.

8. Comparator according to claim 1, further comprising first and second input switches (CE1, CE2) respectively connected to the first and second inputs and commanded to be made conductive during the decision phase.

9. Comparator according to one of claims 1 to 8, in which the comparator (100) further comprises a reference voltage generator (400) intended to impose the second input potential Vᵢₙ₂.

10. Comparator according to claims 8 and 9, in which the reference voltage generator (400) comprises a fourth (C4) capacitor placed between earth and a node B as well as a fifth capacitor (C5) placed between earth and a point C, a switch (CG1) being placed in parallel with the capacitor C4 between the node B and earth, a switch (CG2) being placed between the node B and a point C, a switch (CG3) being placed between the point C and the supply voltage Vdd, the switch (CE2) being placed between the node B and the input In2, the switches (CG1, CG2 and CG3) being commanded to:
- during the pre-charge phase, charge the capacitor (C5) to the voltage Vdd and discharge the capacitor (C4);
- during the sharing phase, share the charges between the capacitors (C4, C5), to obtain a reference voltage at the terminals of the capacitors; and
- during the decision phase, make the switch (CG2) conductive to apply the reference voltage on the second input (In2).

11. Comparator according to one of claims 1 to 10, in which the comparator is a dynamic logic comparator.

12. Comparator according to claim 11, in which the decision stage (200) comprises two inverters, called, respectively, first inverter (210) and second inverter (220), mounted in counter-reaction.

13. Comparator according to claim 12, in which the sources of the NMOS transistors of the first and second inverters are connected, respectively, to the drains of the first (M1) and second (M2) transistors.

14. Imager comprising at least one comparator according to one of claims 1 to 13.
